# EUROPÄISCHE PATENTSCHRIFT

(11) **EP 2 200 141 B1**
(45) Veröffentlichungstag und Bekanntmachung des Hinweises auf die Patenterteilung: **12.10.2011**
(21) Anmeldenummer: 08172053.4
(22) Anmeldetag: 18.12.2008
(51) Int. Cl.: H02H 9/02

(54) **Schaltungsanordnung zum Schutz eines elektrischen Verbrauchers**
Circuit configuration for protecting an electricity consumer
Agencement de commutation destiné à la protection de consommateurs électriques

(43) Veröffentlichungstag der Anmeldung: 23.06.2010
(73) Patentinhaber: Siemens Aktiengesellschaft, 80333 München (DE)
(72) Erfinder: Wagner, Roman, 92224, Amberg (DE)

(56) Entgegenhaltungen:
- EP-A- 0 648 003
- DE-B1- 2 630 065
- US-A- 4 533 970
- US-A- 5 729 418
- US-A- 6 107 664

## Beschreibung

Die Erfindung betrifft eine Schaltungsanordnung zum Schutz eines elektrischen Verbrauchers vor einem Überstrom oder einer Überspannung.

Ein Überstrom oder eine Überspannung führen einem elektrischen Verbraucher soviel elektrische Leistung zu, dass der elektrische Verbraucher beschädigt wird.

Maßnahmen zum Schutz von elektrischen Verbrauchern vor einer Überspannung oder einem Überstrom sind insbesondere dort wichtig, wo ein Hersteller nicht vorhersehen kann, welche Spannungen ein Benutzer eines Bauteils oder Geräts an die Anschlüsse anlegen wird bzw. welche Ströme der Benutzer über die Anschlüsse führen wird.

Dies ist z.B. bei einem analogen Messeingang eines Messmoduls der Fall. Ein Messmodul wird benutzt, um eine unbekannte elektrische Spannung oder einen unbekannten elektrischen Strom zu messen. Zum Messen einer Stromstärke in einem Stromkreis wird ein Messmodul dazu über Anschlüsse des Messeingangs in den Stromkreis geschaltet. Dadurch wird der zu messende Strom über einen Shuntwiderstand des Messmoduls geführt. Dieser Shuntwiderstand ist ein elektrisches Bauteil mit einem geringen, sehr genau bekannten elektrischen Widerstandswert. Durch Messen einer über dem Shuntwiderstand abfallenden Spannung kann somit auf Basis des bekannten Widerstandswerts auf die Stromstärke des durch den Shuntwiderstand fließenden Stroms rückgeschlossen werden.

Bei der Messung der Stromstärke wird in dem Shuntwiderstand elektrische Leistung umgesetzt, die den Shuntwiderstand erhitzt. Überschreitet die Stromstärke in dem Stromkreis einen kritischen Wert, kann der Shuntwiderstand beschädigt werden.

Dabei wird ein Shuntwiderstand oftmals nicht zerstört, sondern sein elektrischer Widerstand wird lediglich dauerhaft verändert. In der Folge sind auch die mit dem Messmodul ermittelten Werte für die Stromstärke verfälscht, ohne dass ein Benutzer dies merkt.

Messmodule befinden sich beispielsweise in Reglern. Mit ihnen werden Istwerte einer Regelgröße erfasst. Ist die Regelgröße dabei bspw. ein Druck oder eine Temperatur, so wird dem Messmodul ein Zweidrahtumformer vorgeschaltet, der einen Strom erzeugt, dessen Stromstärke sich in Abhängigkeit von einem Druck bzw. einer Temperatur verändert. Diese Stromstärke ist dann mit dem Messmodul erfassbar. Bei einem Kurzschluss in dem Zweidrahtumformer fließt ein Überstrom, der einen Shuntwiderstand in dem Messmodul beschädigt, so dass das Messmodul in der Folge die Istwerte nur noch mit einem Fehler misst. Dies ist für einen Benutzer nicht erkennbar, so dass eine Fehlersuche sehr aufwendig ist.

Messmodule befinden sich auch in sogenannten Multimetern zum Messen von elektrischen Größen. Zum Messen einer Stromstärke in einem Stromkreis wird ein Messmodul des Multimeters über Anschlüsse in einen Stromkreis geschaltet. Der zu messende Strom wird so über einen Shuntwiderstand des Messmoduls geführt. Dabei kann es zu den bereits beschriebenen Schäden kommen, wenn ein Überstrom durch den Shuntwiderstand fließt.

Ein Schutz für einen elektrischen Verbraucher wie beispielsweise den Shuntwiderstand eines Messmodules wird im Stand der Technik nur unzulänglich erreicht.

So ist bekannt, einem Shuntwiderstand einen Transistor parallel zu schalten. Bei Auftreten einer Überspannung wird der Transistor leitend geschaltet und so ein Strom an dem Shuntwiderstand vorbeigeführt. Da der parallel geschaltete Transistor für einen effektiven Schutz des Shuntwiderstands dabei einen geringen Widerstandswert aufweisen muss, wird im Fehlerfall ein unerwünscht großer Strom verursacht, der wiederum zu Schäden in dem Transistor selbst führen kann.

Des Weiteren geschieht das Schalten des Transistor durch Erzeugen einer Steuerspannung an seiner Basis. Diese Steuerspannung hängt von einer über dem zu schützenden Verbraucher, also z.B. dem Shuntwiderstand, abfallenden Spannung ab. Tritt anstelle einer Überspannung ein Überstrom auf, löst eine solche Schutzschaltung nicht genauso zuverlässig aus wie eine Überspannung, da bspw. Shuntwiderstände einen sehr geringen elektrischen Widerstandswert haben, so dass auch bei einem Überstrom nur eine geringe Spannung über dem Shuntwiderstand abfällt.

Schließlich wird zum Erzeugen der Steuerspannung eine Spannungsquelle benötigt. Durch eine solche Spannungsquelle wird allerdings auch ein zusätzlicher Strom in den Stromkreis eingebracht, der bspw. in einem Messmodul die Messung des eigentlich zu messenden Stroms verfälscht.

Zum Schutz eines Verbrauchers vor einem Überstrom sind aus dem Stand der Technik Schmelzsicherungen und PTC-Widerstände (PTC - positive temperature coefficient) bekannt, die einem zu schützenden Verbraucher in einem Stromkreis vorgeschaltet werden. Schmelzsicherungen und PTC-Widerstände bewirken einen Schutz dadurch, dass sie durch einen Überstrom erhitzt werden und sie dann den Stromfluss unterbrechen bzw. drosseln. Weil sich diese Elemente allerdings erst erhitzen müssen, weisen sie eine entsprechende Reaktionszeit auf, während der ein Überstrom ungehindert auf den zu schützenden Verbraucher einwirken kann.

**In dem Dokument** US-A-6 107 664 **ist eine Schaltung zur Strombegrenzung offenbart, die als integrierte Halbleiterschaltung bereitgestellt ist. Die Schaltung umfasst drei Transistoren, von denen zwei eine Reihenschaltung zwischen Anschlüssen der Schaltung bilden. Mittels des dritten Transistors wird eine Spannung an einem Steuereingang eines der beiden in Reihe geschalteten Transistoren derart gesteuert, dass dieser bei einer zwischen den Anschlüssen anliegenden Überspannung sperrt.**

**Ein Steuereingang des zweiten der in Reihe geschalteten Transistoren ist derart verschaltet, dass dieser Transistor immer dann sperrt, wenn auch der erste in Reihe geschaltete Transistor sperrt.**

Es ist Aufgabe der vorliegenden Erfindung, einen Schutz für einen elektrischen Verbraucher für den Fall zu schaffen, dass eine elektrische Spannung einen kritischen Spannungswert überschreitet (Überspannung) oder ein Strom mit einer Stromstärke, die größer als ein kritischer Stromwert ist, fließt (Überstrom). Dieser Schutz soll kostengünstig sein und insbesondere für elektrische Verbraucher in einem Messmodul bereitstellbar sein.

Die Aufgabe wird mit einer Schaltungsanordnung gemäß Patentanspruch 1 gelöst. Vorteilhafte Ausführungsformen sind durch die Unteransprüche gegeben.

Eine erfindungsgemäße Schaltungsanordnung zum Schutz eines elektrischen Verbrauchers umfasst
- einen ersten Anschluss und einen zweiten Anschluss, die über einen ersten Transistor miteinander verbunden sind, und
- eine erste Schaltungseinheit, die dazu ausgelegt ist, durch Ändern einer Steuerspannung an einem Steuereingang des ersten Transistors einen Strom durch den ersten Transistor zu reduzieren, wenn eine zwischen den Anschlüssen erfasste erste Spannung einen Spannungswert größer als ein vorgegebener Wert und/oder ein zwischen den Anschlüssen fließender Strom eine Stromstärke größer als ein vorgegebener Wert aufweist, und
- einen zweiten Transistor, der zwischen den ersten Anschluss und den zweiten Anschluss und in Reihe zu dem ersten Transistor geschaltet ist, und
- eine zweite Schaltungseinheit, die dazu ausgelegt ist, in Abhängigkeit von einer über dem ersten Transistor abfallenden Spannung eine Steuerspannung an einem Steuereingang des zweiten Transistors derart zu ändern, dass der Strom durch den ersten Transistor reduziert wird, wenn ein Betrag der über dem ersten Transistor abfallenden Spannung steigt.

**Bei einer erfindungsgemäßen Schaltungsanordnung** umfasst die erste Schaltungseinheit zum Erzeugen einer Steuerspannung eine erste und eine zweite Schaltungsstrecke, über denen jeweils die zu überwachende erste Spannung abfällt.

Die erste Schaltungsstrecke umfasst dabei einen Widerstand und wenigstens ein weiteres Element, über dem wenigstens ein Anteil der ersten Spannung abfällt. Bevorzugt ist ein solches weiteres Element eine Zenerdiode. Anstelle einer Zenerdiode kann aber auch einfach ein weiterer Widerstand vorgesehen sein, so dass in der ersten Schaltungsstrecke ein Spannungsteiler gebildet ist.

Die zweite Schaltungsstrecke umfasst wenigstens einen dritten Transistor. Elektrische Verbindungen sind derart vorgesehen, dass eine Steuerspannung an einem Steuereingang des dritten Transistors in Abhängigkeit von einer über dem Widerstand abfallenden Spannung gebildet ist und eine über dem dritten Transistor abfallende Spannung die Steuerspannung an dem Steuereingang des ersten Transistors **bildet.**

Durch eine solche Schaltungsanordnung lässt sich ein Strom durch einen Verbraucher reduzieren, sobald dieser Strom eine für den Verbraucher gefährliche Stromstärke erreicht. Zusätzlich ist es möglich, bei einer an den Anschlüssen anliegenden Überspannung einen Verbraucher dadurch zu schützen, dass ein überwiegender Teil der Überspannung über den sperrenden Transistoren, d.h. dem ersten und dem zweiten Transistor, und nicht über dem Verbraucher abfällt.

Durch die Reihenschaltung aus einem ersten und einem zweiten Transistor sowie die Kopplung dieser beiden Transistoren über die zweite Schaltungseinheit wird der Strom bereits dann wirksam reduziert, wenn die zu überwachende ersten Spannung nur geringfügig über dem vorgegebenen Wert liegt oder der Strom die maximal zulässige Stromstärke nur geringfügig überschreitet. Die Schaltungsanordnung weist somit eine hohe Sensitivität auf.

Des Weiteren wird der Verbraucherstrom mit einer sehr geringen zeitlichen Verzögerung reduziert, nachdem die erste Schaltungseinheit einen Überstrom oder eine Überspannung erkannt hat. Anders als bei den im Stand der Technik verwendeten Schmelzsicherungen oder PTC-Widerständen kann durch ein direktes Überwachen einer Spannung oder eines Stroms mittels der ersten Schaltungseinheit ein Strom schneller reduziert werden.

Schließlich erhitzt sich die Schaltungsanordnung im Falle eines Überstroms oder einer Überspannung nicht, da durch das Sperren des Stroms die Leistungsaufnahme der Schaltungsanordnung im Fehlerfall sehr gering ist.

Die Anschlüsse der Schaltungsanordnung können durch Stecker und vergleichbare Anschlussvorrichtungen gebildet sein. Es kann sich bei den Anschlüssen aber auch lediglich um leitende Verbindungen der Schaltungsanordnung handeln, wenn die Schaltungsanordnung z.B. in einen größeren Schaltkreis integriert ist.

Die zwischen den Anschlüssen erfasste erste Spannung kann die ganze zwischen dem ersten und dem zweiten Anschluss anliegende Spannung oder auch nur eine Teilspannung davon sein.

Die beiden Anschlüsse werden über die Transistoren jeweils vorzugsweise über deren Kollektor-Emitter-Strecke bzw. deren Drain-Source-Strecke verbunden. Ein Steuereingang eines Transistors wird vorzugsweise durch die Basis bzw. das Gate des Transistors **gebildet.**

**Die** erste Schaltungseinheit benötigt keine zusätzliche Spannungsquelle, da sämtliche Elemente zum Erkennen einer Überspannung und eines Überstroms mit der zwischen den Anschlüssen abfallenden Spannung betrieben werden können. Damit wird durch die erfindungsgemäße Schaltungsanordnung kein zusätzlicher Strom aus einer weiteren Spannungsquelle in den Stromkreis eingebracht. Die Schaltungsanordnung bildet somit einen Zweipol, bei dem der durch den einen Anschluss in die Schaltungsanordnung hineinfließende Strom gleich dem aus dem zweiten Anschluss fließenden Strom ist. Insbesondere bei Messmodulen wird so durch die erfindungsgemäße Schaltungsanordnung ein Messstrom nicht verfälscht. Dies ist auch dann der Fall, wenn in der ersten oder der zweiten Schaltungsstrecke weitere Bauelemente vorhanden sind.

Die Schaltungsstrecken werden durch die Gesamtheit derjenigen Schaltungselemente gebildet, die zwei Pole oder Knoten der Schaltungsanordnung miteinander verbinden.

Wenigstens eine der Schaltungsstrecken weist in vorteilhafter Weise ein Element auf, mit dem in Abhängigkeit von einem Strom durch die jeweilige Schaltungsstrecke ein Signal in einem galvanisch von der jeweiligen Schaltungsstrecke getrennten Schaltkreis erzeugbar ist. Ein solches Element kann insbesondere ein Optokoppler sein. Alternativ zu einem Optokoppler ist aber auch beispielsweise ein Magnet-Koppler, ein kapazitiver Koppler oder sogar ein Relais möglich.

Mit einem solchen Element kann ein Signal ausgekoppelt werden, das angibt, wenn eine Überspannung oder ein Überstrom vorliegt. Dabei wird ein Strom durch die Schaltungsanordnung wegen der galvanischen Trennung nicht verfälscht. Mit diesem Element kann einem Benutzer angezeigt werden, dass eine an die Anschlüsse der Schaltungsanordnung angelegte Spannung zu hoch oder ein über die Anschlüsse geführter Strom zu stark ist. Bei Messmodulen ist für einen Benutzer somit erkennbar, dass ein in dem Messmodul zum Erfassen einer Stromstärke verwendeter Shuntwiderstand evtl. beschädigt worden ist, wodurch eine Fehlersuche erleichtert wird.

Der erste Transistor und der zweite Transistor sind vorzugsweise jeweils ein Feldeffekttransistor (FET), insbesondere ein MOSFET (Metal-Oxide-Semiconductor FET), wobei die Anschlüsse der Schaltungsanordnung über eine jeweilige Drain-Source-Strecke der Feldeffekttransistoren miteinander verbunden sind.

Die Reihenschaltung der Drain-Source-Strecken des ersten und des zweiten Transistors verhält sich dann im leitenden Zustand linear. Mit anderen Worten: Bei einer Drain-Source-Strecke eines FETs ist eine über dieser Strecke abfallende Spannung im leitenden Zustand des FET proportional zu dem Strom, der über diese Strecke geführt wird. Dadurch können sehr geringe Ströme über die gesamte Schaltungsanordnung geführt werden, ohne dass ein solcher Strom bei unterschreiten eine bestimmten Stromstärke von den Transistoren unterbrochen würde, wie es normalerweise bei PN-Übergängen z.B. von Bipolartransistoren der Fall ist. Bei Messmodulen können somit trotz der in den Schaltkreis geschalteten Schaltungsanordnung zum Schutz der Messmoduls auch geringe Ströme genau gemessen werden.

Der erste Transistor ist dabei bevorzugt ein selbstsperrender FET und der zweite Transistor ein selbstleitender FET. Die zweite Schaltungseinheit umfasst dabei eine elektrisch leitende Verbindung zwischen einem Gate-Anschluss des zweiten Transistors und einem Source-Anschluss des ersten Transistors.

Selbstleitende FETs bzw. selbstsperrende FETs sind Typen von FETs, die bei Anlegen einer Gate-Source-Spannung von 0 V für einen Strom über die Drain-Source-Strecke durchlässig bzw. undurchlässig sind. Andere Bezeichnungen sind Verarmungstyp bzw. Anreicherungstyp.

Indem ein selbstsperrender FET als erster Transistor bereitgestellt ist und ein selbstleitender FET als zweiter Transistor, können die erste und die zweite Schaltungseinheit derart ausgebildet werden, dass sie nahezu keine Leistung verbrauchen, wenn kein Überstrom bzw. keine Überspannung vorliegen (Normalbetrieb). Die Leistungsaufnahme durch die beiden Schaltungseinheiten begrenzt sich dabei auf durch Leckströme hervorgerufene Verluste. Die erfindungsgemäße Schaltungsanordnung weist somit einen sehr geringen Energiebedarf auf.

Bei einer bevorzugten, besonders einfach zu realisierenden Weiterbildung dieser Ausführungsform ist die oben genannte elektrisch leitende Verbindung zwischen dem Gate-Anschluss und dem Source-Anschluss einfach ein Kurzschluss. Durch Bereitstellen einer Leiterbahn oder einer Leitung zwischen dem Gate-Anschluss des zweiten Transistors und dem Source-Anschluss des ersten Transistors kann bereits eine Kopplung zwischen den beiden Transistoren bewirkt werden, die zu der gewünschten hohen Sensitivität der Schaltungsanordnung führt.

Bei allen bisher beschriebenen Schaltungsanordnungen ist in einer bevorzugten Weiterbildung bei der ersten Schaltungseinheit ein Eingangssignal gleichgerichtet. Dadurch lässt sich die erfindungsgemäße Schaltungsanordnung unabhängig von der Polung einer zwischen den Anschlüssen der Schaltungsanordnung anliegenden Spannung bzw. unabhängig von der Richtung eines über die Anschlüsse fließenden Stroms einsetzen. Sie ist damit für einen bipolaren Betrieb geeignet.

Dabei ist es vorteilhaft, wenn die erste Schaltungseinheit mit einem Ausgang eines Brückengleichrichters verbunden ist und an einem Eingang des Brückengleichrichters ein Widerstand dem Brückengleichrichter parallel geschaltet ist. Der Brückengleichrichter kann beispielsweise mittels Halbleiterelementen wie Schottky-Dioden gebaut sein. Durch einen die beiden eingangsseitigen Kontakte des Brückengleichrichters verbindenden Widerstand kann zwischen diesen beiden Kontakten auch dann ein Strom fließen, wenn die Spannung zwischen den Kontakten kleiner als die Durchlassspannung der Halbleiterelemente des Brückengleichrichters ist. Dies ist insbesondere dann vorteilhaft, wenn nicht nur die erste Schaltungseinheit, sondern auch die Reihenschaltung aus dem ersten und dem zweiten Transistor an dem Ausgang des Brückengleichrichters angeschlossen sind. Durch den parallelen Widerstand am Eingang des Brückengleichrichters weist die Schaltungsanordnung insgesamt auch bei geringen Spannungen ein lineares Verhalten auf.

Alternativ zu einem Gleichrichter kann in Reihe zu dem ersten und dem zweiten Transistor ein vierter und ein fünfter Transistor zwischen die Anschlüsse geschaltet sein und eine dritte Schaltungseinheit dazu ausgelegt sein, den vierten Transistor durch Ändern einer Steuerspannung an einem Steuereingang des vierten Transistors in Abhängigkeit von einer zwischen den Anschlüssen erfassten zweiten Spannung zu steuern, wobei die zweite Spannung gegensinnig zu der ersten Spannung erfasst wird.

Diese Ausführungsform ist ebenfalls für einen bipolaren Betrieb geeignet. Es handelt sich bei der Ausführungsform um eine antiparallele Anordnung zweier Schutzschaltungen, die jeweils einen Schutz für eine Strom- oder Spannungsrichtung bewirken. Die bei gegebener Polarität einer Spannung an den Eingängen nicht zum Schutz beitragenden Transistoren können dabei beispielsweise durch parallel zu den Transistoren geschaltete Dioden überbrückt werden (Bypass-Dioden). Bei MOSFETs sind solche Bypass-Dioden bereits in Form von parasitären Dioden in den MOSFETs enthalten. Bei FETs ist es auch generell möglich, die nicht zum Schutz benötigten FETs leitend zu schalten.

Zur Erfindung gehört auch ein Messmodul mit einem analogen Messeingang, wobei zwei Anschlusskontakte des Messeingangs über eine erfindungsgemäße Schaltungsanordnung zum Schutz eines elektrischen Verbrauchers verbunden sind. Damit ist es möglich, die Messschaltung des Messmoduls vor einem Überstrom oder einer Überspannung zu schützen.

Die Erfindung wird im Folgenden anhand von Ausführungsbeispielen näher erläutert. Dazu zeigen
- FIG 1: eine Schaltung eines Messmoduls mit einem daran ange- schlossenen Zweidrahtumformer, wobei in dem Messmodul eine Ausführungsform der erfindungsgemäßen Schal- tungsanordnung verwendet ist,
- FIG 2: eine Ausführungsform einer erfindungsgemäßen Schal- tungsanordnung für einen unipolaren Betrieb,
- FIG 3: eine Ausführungsform einer erfindungsgemäßen Schal- tungsanordnung mit einem Brückengleichrichter für ei- nen bipolaren Betrieb der Schaltungsanordnung und
- FIG 4: eine Ausführungsform einer erfindungsgemäßen Schal- tungsanordnung für einen bipolaren Betrieb bestehend aus einer antiparallelen Anordnung zweier Schutz- schaltungen.

Die nachfolgenden Beispiele stellen bevorzugte Ausführungsformen der Erfindung dar.

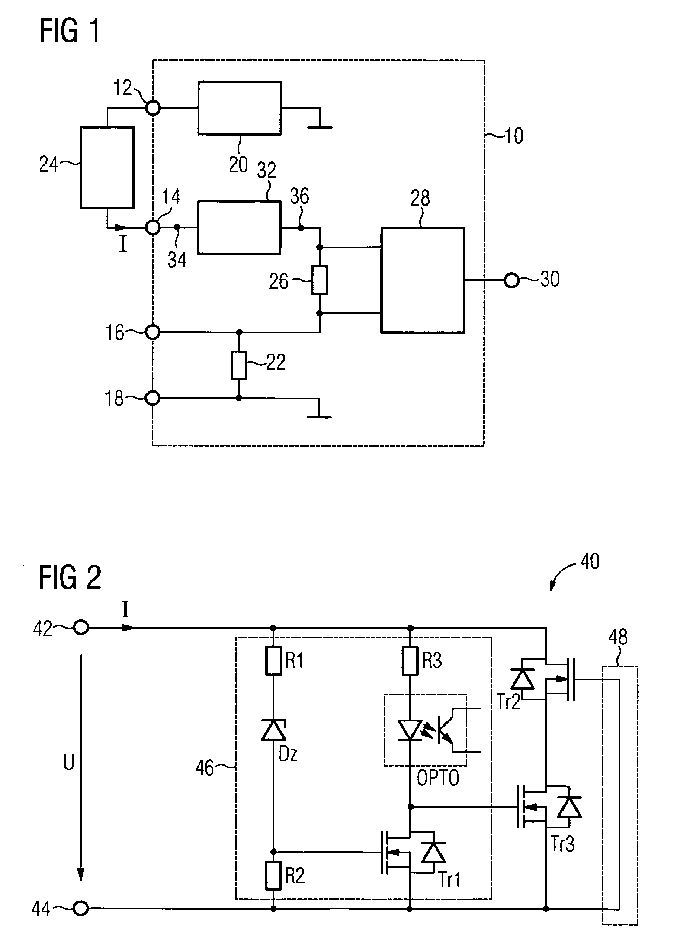

In dem Beispiel von FIG 1 ist ein Messmodul 10 dargestellt, das als Schaltungsplatine verfügbar ist und in einen in FIG 1 nicht dargestellten Regler eingebaut ist. Das Messmodul 10 weist Anschlüsse 12, 14, 16, 18 auf, über die ein Benutzer das Messmodul 10 mit weiteren Schaltungen verbinden kann. Dabei ist an einem ersten Anschluss 12 eine Versorgungsspannung abgreifbar, die von einer Spannungsquelle 20 des Messmoduls 10 bereitgestellt wird. Ein zweiter Anschluss 18 ist ein Masseanschluss. Die übrigen beiden Anschlüsse 14, 16 bilden zusammen einen analogen Messeingang, über den eine Spannung oder eine Stromstärke erfasst werden kann. Dabei ist ein Anschluss 16 über einen Widerstand 22 mit der Masseleitung des Anschlusses 18 für die Masse der Spannungsquelle 20 verbunden.

An das Messmodul 10 ist ein Zweidrahtumformer 24 angeschlossen, der von einem Strom I durchflossen wird. Der Strom ist von der Spannungsquelle 20 bereitgestellt. Dabei ändert sich eine Stromstärke des Stroms I in Abhängigkeit z.B. von einem Luftdruck, der auf den Zweidrahtumformer einwirkt. Durch Messen der Stromstärke des Stroms I ist es somit möglich, auf den Luftdruck zurückzuschließen. Der Zweidrahtumformer 24 lässt sich durch andere Umformer auswechseln, so dass auch andere physikalische Größen, z.B. eine Temperatur, erfasst werden können.

Zum Messen der Stromstärke des Stroms I ist der Zweitdrahtumformer 24 mit einem Anschluss 14 des analogen Messeingangs verbunden. In dem Messmodul 10 ist der Strom I über einen Shuntwiderstand 26 geführt. Geschlossen wird der Stromkreis über den Widerstand 22, der den Shuntwiderstand 26 mit der Masse der Spannungsquelle 20 verbindet.

Eine über dem Shuntwiderstand 26 abfallende Spannung wird von einem Analog-Digital-Wandler 28 erfasst und in einen digitalen Wert gewandelt. Der vom Analog-Digital-Wandler 28 bereitgestellte digitale Wert kann an einem Ausgang 30 des Analog-Digital-Wandlers 28 ausgelesen werden. In einer anderen (in FIG 1 nicht dargestellten) Ausführungsform des Messmoduls sind ein Shuntwiderstand und ein Analog-Digital-Wandler über eine Verstärkerschaltung gekoppelt, welche die über einem Shuntwiderstand abfallende Spannung zunächst verstärkt, um den nachgeschalteten Analog-Digital-Wandler besser auszusteuern.

Eine Schutzschaltung 32 des Messmoduls 10 schützt den Shuntwiderstand 26 davor, durch eine zu große Stromstärke des Stroms I beschädigt zu werden. Die Stromstärke wird insbesondere dann sehr groß, wenn der Zweidrahtumformer 24 defekt ist und deshalb einen Kurzschluss zwischen den Anschlüssen 12 und 14 bildet. Die Schutzschaltung 32 bietet auch einen Schutz vor einer zu großen Spannung, die ein Benutzer beispielsweise zwischen den Anschlüssen 14, 16 anlegen könnte.

Die Schutzschaltung 32 ist durch eine Ausführungsform der erfindungsgemäßen Schaltungsanordnung gebildet. Sie ist über zwei Kontakte 34, 36 in Reihe mit dem Shuntwiderstand 26 geschaltet. Die Schutzschaltung 32 ist vorliegend als Teil der Schaltung auf der Schaltungsplatine des Messmoduls 10 integriert. Daher sind die Kontakte 34, 36 lediglich zwei beliebige Punkte auf der Leiterbahn. Da die **Schutzschaltung** 32 nur über zwei Kontakte 34, 36 in den Schaltkreis geschaltet ist, bildet sie einen Zweipol. Durch sie wird der zu messenden Strom I nicht verfälscht.

Des Weiteren ist ein Zusammenhang zwischen dem durch die Schutzschaltung 32 fließenden Strom I und einer über der Schutzschaltung 32 abfallenden Spannung weitestgehend linear. Dadurch ergibt sich der Vorteil, dass eine stetige Änderung der von dem Zweidrahtumformer erfassten physikalischen Größe (Druck, Temperatur) auch in einer stetigen Änderung der über dem Shuntwiderstand 26 abfallenden Spannung resultiert. Ein nicht-lineares Verhalten der Schutzschaltung 32 würde bei einer Messungen der physikalischen Größe beispielsweise eine sprunghafte Änderung der Spannung am Shuntwiderstand 26 bewirken und dadurch zu einem unerwünschten Verhalten des Reglers führen.

In FIG 2 ist ein Schaltplan einer Ausführungsform einer erfindungsgemäßen Schaltungsanordnung gezeigt. Diese Schutzschaltung 40 kann über zwei Anschlüsse 42, 44 in eine Leitung geschaltet werden, so dass ein durch die Leitung fließender Strom I über die Schutzschaltung 40 geführt ist. Über der Schutzschaltung 40 fällt eine Spannung U ab.

Wenn der Strom I eine Stromstärke kleiner als ein vorgegebener kritischer Stromstärkewert aufweist, befindet sich die Schutzschaltung 40 in einem Normalbetrieb. Übersteigt die Stromstärke des Stroms I den kritischen Wert (Überstrom) oder fällt zwischen den Anschlüsse 42, 44 eine Spannung ab, die größer als ein kritischer Spannungswert ist (Überspannung), so schaltet die Schutzschaltung in einen Sperrbetrieb.

Im Normalbetrieb befinden sich die Transistoren Tr2 und Tr3 in einem leitenden Zustand, so dass der Strom I fast vollständig durch die Transistoren Tr2 und Tr3 fließt. Beide Transistoren sind hier Feldeffekttransistoren (FET), nämlich MOSFET (metal-oxide-semiconductor FET), wobei der Strom I über deren Drain-Source-Strecken geführt ist. Dadurch ist die Spannung U im Normalbetrieb proportional zu dem zwischen den Anschlüssen 42, 44 fließenden Strom I, d.h. die Schutzschaltung verhält sich linear.

Der Transistor Tr3 ist ein selbstsperrender FET. Der Strom durch den Transistor Tr3 ist über einen Steuereingang, das Gate des FET, von einer Schaltungseinheit 46 gesteuert. Eine Steuerspannung an dem Gate wird hierbei als Gate-Source-Spannung an dem Transistor Tr3 angelegt. Entsprechendes gilt auch für die übrigen Transistoren der in FIG 2 gezeigten Schutzschaltung 40.

In sämtlichen Figuren sind innerhalb eines MOSFETs auftretende parasitäre Effekte als parallel zu dem jeweiligen MOSFET geschaltete Dioden symbolisiert.

Die Schaltungseinheit 46 besteht aus zwei Schaltungszweigen, über denen jeweils die Spannung U abfällt, also diejenige Spannung, die auch über der Reihenschaltung aus den beiden Transistoren Tr2, Tr3 abfällt. Der erste Schaltungszweig umfasst zwei Widerstände R1, R2 und eine Zenerdiode Dz. Der zweite Schaltungszweig umfasst einen Widerstand R3, einen Optokoppler OPTO und einen dritten Transistors Tr1, der ebenfalls ein MOSFET ist. Das Gate des Transistors Tr1 ist mit dem ersten Schaltungszweig gekoppelt, so dass die Gate-Source-Spannung des Transistors Tr1 identisch mit der Spannung über dem Widerstand R2 ist.

Im Normalbetrieb fällt innerhalb des ersten Schaltungszweigs die Spannung U vollständig über der Zenerdiode Dz ab, und es fließt kein Strom durch den ersten Schaltungszweig (bis auf einen eventuellen Leckstrom). Daher fällt keine Spannung über dem Widerstand R2 ab, und der Transistor Tr1 sperrt.

Mit sperrendem Transistor Tr1 fällt innerhalb des zweiten Schaltungszweigs die Spannung U vollständig über der Drain-Source-Strecke des Transistors Tr1 ab. Über eine Verbindung zum Gate des Transistors Tr3 wird erreicht, dass die über dem Transistor Tr1 abfallende Spannung als Steuerspannung zum Steuern eines Stroms durch den Transistor Tr3 fungiert. Der Transistor Tr3 wird somit im Normalbetrieb durch die über dem Transitor Tr1 abfallende Spannung U **in dem leitenden Zustand gehalten.** Für den Fall, dass die Schutzschaltung 40 in Schaltungen mit verhältnismäßig hohen Spannungen eingesetzt werden soll, kann durch einfache fachmännische Maßnahmen (z.B. einen Spannungsteiler) erreicht werden, dass nur ein Teil der über dem Transistor Tr1 abfallenden Spannung als Steuerspannung an dem Gate des Transistors Tr3 anliegt.

Der Transistor Tr3 ist mit dem Transistor Tr2 über eine zweite Schaltungseinheit 48 gekoppelt, so dass der Transistor Tr2 immer dann in einen leitenden Zustand geschaltet wird, wenn auch der Transistor Tr3 leitet. Vorliegend ist diese zweite Schaltungseinheit 48 lediglich ein Kurzschluss zwischen einem Gate-Anschluss des Transistors Tr2 und einem Source-Anschluss des Transistors Tr3. Diese besonders einfach herzustellende Ausführungsform ist durch die Wahl der Transistortypen für die Transistoren Tr2 und Tr3 ermöglicht. Bei einer Ausführungsform, die ausschließlich selbstsperrende FETs oder sogar Bipolartransistoren **verwendet,** ist die zweite Schaltungseinheit entsprechend aufwändiger zu gestalten, um die gewünschte Kopplung zwischen den Transistoren zu erhalten.

Da die beiden Schaltungszweige im Normalbetrieb nur Leckströme führen und der Widerstand der Reihenschaltung aus den beiden Transistoren Tr2 und Tr3 sehr gering ist, wird in der Schutzschaltung 40 verhältnismäßig wenig elektrische Leistung umgesetzt. Sie muss daher nicht gekühlt werden. Außerdem kann sie in eine Schaltung eingebracht werden, ohne dass die Leistungsfähigkeit der Spannungsquelle dieser Schaltung erhöht werden müsste.

Die Schutzschaltung 40 schaltet vom Normalbetrieb in den Sperrbetrieb, wenn die Spannung U einen vorgegebenen Wert übersteigt. Dies kann direkt durch Anlegen einer entsprechend hohen Spannung U an die Anschlüsse 42, 44 passieren (Überspannung) oder dadurch, dass die Stromstärke des Stroms I so groß wird (Überstrom), dass die über den Transistoren Tr2 und Tr3 abfallende Spannung entsprechen hoch wird.

In beiden Fällen wird die Zenerdiode Dz leitend. Dann fließt ein Strom durch den Widerstand R2. Der Wert, bei dem die Zenerdiode Dz leitend wird, ist dabei durch die Wahl der Zenerdiode Dz bestimmbar. Wegen des Stroms durch den Widerstand R2 fällt eine Spannung über diesem ab. Diese bewirkt, dass der Transistor Tr1 in einen leitenden Zustand übergeht. Im leitenden Zustand hat der Transistor Tr1 einen sehr geringen Widerstand, so dass die über ihm abfallende Spannung ebenfalls sehr gering ist. **Da** diese Spannung die Steuerspannung für den Transistor Tr3 bildet, wird dieser wegen der kleinen Steuerspannung in einen sperrenden Zustand **überführt,** und der durch den Transistor Tr3 fließende Strom wird reduziert. Dies verringert den Gesamtstrom I durch die Schutzschaltung 40. Gleichzeitig fällt damit über dem Transistor Tr3 eine ausreichend hohe Spannung ab, um auch den über den Kurzschluss der zweiten Schaltungseinheit 48 gekoppelten Transistor Tr2 sperrend zu schalten. Dadurch wird der Übergang vom Normalbetrieb in den Sperrbetrieb begünstigt. Somit ist es hier möglich, einen Strom innerhalb von wenigen Mikrosekunden zu unterbrechen, wenn die Spannung U sprunghaft auf eine Überspannung anwächst.

Die Widerstände R1 und R3 sind so gewählt, dass die Schutzschaltung 40 im Sperrbetrieb einen für einen zu schützenden Verbraucher ungefährlichen, kleinen Strom führt. Die Schutzschaltung 40 nimmt dabei auch im Sperrbetrieb nur sehr wenig elektrische Leistung auf.

Da der Optokoppler OPTO im Normalbetrieb stromlos ist, im Sperrbetrieb dagegen von einem Strom durchflossen wird, kann über eine in FIG 2 nicht dargestellte Überwachungsschaltung erkannt werden, ob sich die Schutzschaltung 40 im Normalbetrieb oder im Sperrbetrieb befindet. Da der Optokoppler OPTO den zweiten Schaltungszweig galvanisch von der Überwachungsschaltung trennt, wird der Strom I durch die Schutzschaltung 40 nicht durch die Überwachungsschaltung beeinflusst.

Die Überwachungsschaltung ist dazu ausgebildet, einem Benutzer zu signalisieren, wenn ein Überstrom bzw. eine Überspannung vorliegt.

In allen Zuständen der beschriebenen Schutzschaltung ist ein sicherer und nahezu temperaturunabhängiger Schutz eines zur Schutzschaltung in Reihe geschalteten elektrischen Verbrauchers möglich. Die Schutzschaltung ist als Zweipol ausgeprägt und benötigt keine zusätzliche Versorgung. Wird die Schutzschaltung bspw. in einem Messmodul eingesetzt, so wird die Genauigkeit des Messmoduls durch die Schutzschaltung nicht beeinträchtigt, da es keine Leckströme gibt, die an einer Messschaltung des Messmoduls vorbeigeführt werden.

Die beschriebene Schutzschaltung weist sowohl im Normalbetrieb als auch im Sperrbetrieb nur geringe elektrische Verluste auf.

In anderen, hier nicht dargestellten Ausführungsformen der Erfindung ist die Schutzschaltung mit einem ESD-Schutz (ESD - elctrostatic discharge) bzw. mit einer Temperaturüberwachung für eine temperaturabhängige Strombegrenzung ausgebildet. Eine weitere Ausführungsform umfasst ein Verzögerungsglied, z.B. ein RC-Glied, damit ein hoher Einschaltstrom eines zu schützenden Verbrauchers nicht durch die Schutzschaltung blockiert wird.

Schließlich ist die erfindungsgemäße Schaltungsanordnung in einer weiteren Ausführungsform dazu ausgebildet, einen Ladestrom für einen Pufferkondensator zu begrenzen.

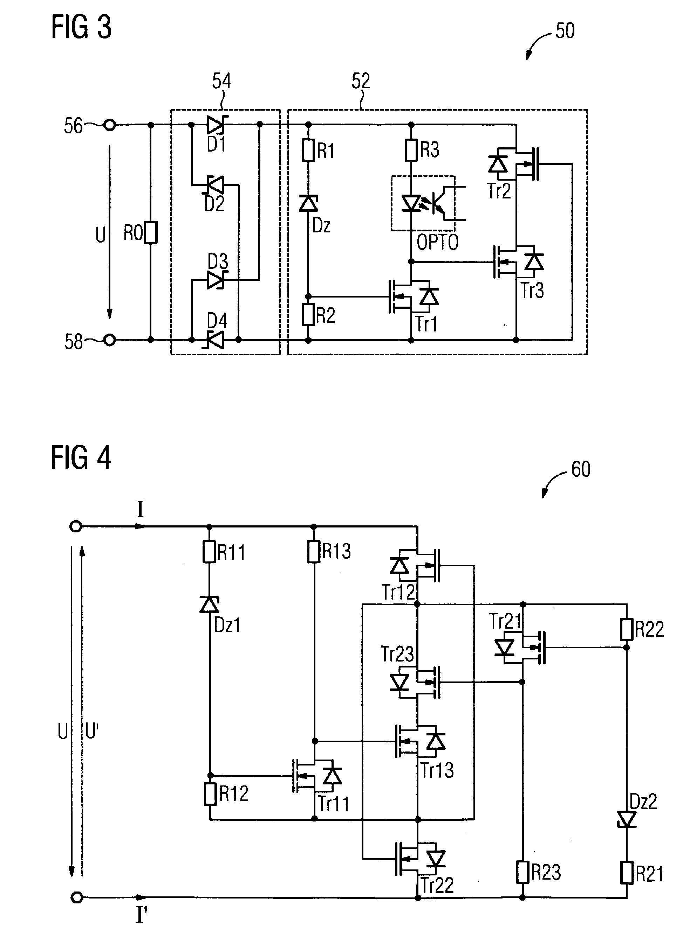

In FIG 3 ist die Schaltung einer Ausführungsform der erfindungsgemäßen Schaltungsanordnung gezeigt, die für einen bipolaren Betrieb ausgelegt ist. Die in FIG 3 gezeigte Schutzschaltung 50 weist einen unipolar zu betreibenden Schaltungsteil 52 auf, der einen mit der in FIG 2 gezeigten Schaltung identisch ist. Daher werden die zum Schaltungsteil 52 gehörigen Bauteile in ihrer Funktionsweise nicht noch einmal erläutert.

Das Eingangssignal für diesen unipolaren Schaltungsteil 52 ist gleichgerichtet. Dazu ist der Schaltungsteil 52 mit dem Ausgang eines Brückengleichrichters 54 verbunden. Der Brückengleichrichter 54 ist in der in FIG 3 gezeigten Schaltung aus vier Schottky-Dioden D1, D2, D3, D4 gebildet.

Durch den Brückengleichrichter 54 fällt insbesondere über der Zenerdiode Dz und über dem Optokoppler OPTO des Schaltungsteils 52 eine Spannung ab, die unabhängig von einer Eingangsspannung U der Schutzschaltung 50 immer dieselbe Polarität hat.

An einem Eingang des Brückengleichrichters 54 verbindet ein Widerstand R0 die beiden Anschlüsse des Brückengleichrichters. Dadurch verhält sich die Schutzschaltung 50 bzgl. der Anschlüsse 56, 58 auch dann wie ein lineares Bauteil, wenn die Eingangsspannung U so gering ist, dass alle Schottky-Dioden D1, D2, D3, D4 der Gleichrichterbrücke 54 sperren.

In FIG 4 ist die Schaltung einer weiteren Ausführungsform der erfindungsgemäßen Schaltungsanordnung gezeigt, die ebenfalls für einen bipolaren Betrieb geeignet ist. Die in FIG 4 gezeigte Schutzschaltung 60 ist aus zwei Schaltungsteilen gebildet, die Ströme I, I' mit entgegengesetzten Polaritäten reduzieren können. Diese Ströme I, I' sind in FIG 4 durch entgegengesetzte Zählpfeile symbolisiert. Zu diesen entgegengesetzten Strömen I, I' gehören entsprechend gegensinnige Eingangsspannungen U, U'.

Ein erster Schaltungsteil umfasst dabei MOSFETs **Tr11,** Tr12 und Tr13, Widerstände R11, R12 und R13 sowie eine Zenerdiode Dz1. Dieser Schaltungsteil reduziert den Strom I für den Fall, dass seine Stromstärke einen bestimmten Wert übersteigt oder die Spannung U einen vorbestimmten Wert übersteigt.

Ein zweiter Schaltungsteil umfasst MOSFETs Tr23, Tr22 und Tr21, Widerstände R21, R22 und R23 sowie eine Zenerdiode Dz2. Dieser Schaltungsteil reduziert einen Strom I' im Falle eines **Überstroms** oder einer Überspannung. Die von diesem zweiten Schaltungsteil überwachte Spannung U' wird dabei gegensinnig zu der Spannung U erfasst.

Die beiden Schaltungen hindern sich in ihrer Funktionsweise nicht gegenseitig, da parasitäre Dioden in den MOSFETs Tr12, Tr13, Tr22 und Tr23 einen MOSFET für einen Strom gegebenenfalls durchlässig machen.

Die beiden Schaltungsteile erfassen jeweils nicht die vollständige Spannung U bzw. U', sondern nur eine Teilspannung davon. Der **verbleibende** Teil ist diejenige Spannung, die an den Transistoren Tr12 bzw. Tr22 abfällt. Dieser Spannungsabfall ist allerdings bekannt. Deshalb können die Zenerdioden Dz1 und Dz2 so gewählt werden, dass auch durch Messen der Teilspannungen erkannt wird, wenn ein schädlicher Überstrom bzw. eine schädliche Überspannung vorliegt.

Die in FIG 4 gezeigte Schaltung ist als integrierte Schaltung (IC - integrated circuit) bereitgestellt und kann beispielsweise in einem Multimeter oder in einem Messmodul für einen Regler als Zweipol (mit linearer Kennlinie) in einem Schaltkreis untergebracht werden. In einer weiteren, hier nicht dargestellten Ausführungsform der Erfindung weist die integrierte Schaltung mehrere Kanäle auf.

Insgesamt ist durch die in den Figuren gezeigten Ausführungsbeispiele gezeigt, wie sich elektrische Verbraucher durch die erfindungsgemäße Schaltungsanordnung gegen einen Überstrom oder eine Überspannung schützen lassen.

## Patentansprüche

1. Schaltungsanordnung zum Schutz eines elektrischen Verbrauchers (26), umfassend
- einen ersten Anschluss (42) und einen zweiten Anschluss (44), die über einen ersten Transistor (Tr3) miteinander verbunden sind, und
- eine erste Schaltungseinheit (46), die dazu ausgelegt ist, durch Ändern einer Steuerspannung an einem Steuereingang des ersten Transistors (Tr3) einen Strom durch den ersten Transistor (Tr3) zu reduzieren, wenn eine zwischen den Anschlüssen (42, 44) erfasste erste Spannung einen Spannungswert größer als ein vorgegebener Wert und/oder **wenn** ein zwischen den Anschlüssen fließender Strom eine Stromstärke größer als ein vorgegebener Wert aufweist, und
- einen zweiten Transistor (Tr2), der zwischen den ersten Anschluss (42) und den zweiten Anschluss (44) und in Reihe zu dem ersten Transistor (Tr3) geschaltet ist, und
- eine zweite Schaltungseinheit (48), die dazu ausgelegt ist, in Abhängigkeit von einer über dem ersten Transistor (Tr3) abfallenden Spannung eine Steuerspannung an einem Steuereingang des zweiten Transistors (Tr2) derart zu ändern, dass der Strom durch den ersten Transistor (Tr3) reduziert wird, wenn ein Betrag der über dem ersten Transistor (Tr3) abfallenden Spannung **steigt,**
**dadurch gekennzeichnet, dass**
- die erste Schaltungseinheit (46) eine erste und eine zweite Schaltungsstrecke umfasst, über denen jeweils die erste Spannung abfällt, wobei
- die erste Schaltungsstrecke einen Widerstand (R2) und wenigstens ein weiteres Element umfasst, wobei über dem weiteren Element wenigstens ein Anteil der ersten Spannung abfällt, und
- die zweite Schaltungsstrecke einen dritten Transistor (Tr1) umfasst, und wobei
- elektrische Verbindungen derart vorgesehen sind, dass eine Steuerspannung an einem Steuereingang des dritten Transistors (Tr1) in Abhängigkeit von einer über dem Widerstand (R2) abfallenden Spannung gebildet ist und
- die Steuerspannung an dem Steuereingang des ersten Transistors (Tr3) von einer über dem dritten Transistor (Tr1) abfallenden Spannung abhängig ist.

2. Schaltungsanordnung nach Anspruch **1,**
**dadurch gekennzeichnet, dass** wenigstens eine der Schaltungsstrecken ein Element, insbesondere einen Optokoppler (OPTO), umfasst, mit dem in Abhängigkeit von einem Strom durch die jeweilige Schaltungsstrecke ein Signal in einem galvanisch von der jeweiligen Schaltungsstrecke getrennten Schaltkreis erzeugbar ist.

3. Schaltungsanordnung nach **Anspruch 1 oder 2,**
**dadurch gekennzeichnet, dass** der erste Transistor (Tr3) und der zweite Transistor (Tr2) jeweils ein Feldeffekttransistor, insbesondere ein MOSFET, ist, wobei die Anschlüsse der Schaltungsanordnung über eine jeweilige Drain-Source-Strecke der Feldeffekttransistoren miteinander verbunden sind.

4. Schaltungsanordnung nach Anspruch **3,**
**dadurch gekennzeichnet, dass** der erste Transistor (Tr3) ein selbstsperrender Feldeffekttransistor und der zweite Transistor (Tr2) ein selbstleitender Feldeffekttransistor ist und die zweite Schaltungseinheit (48)eine elektrisch leitende Verbindung zwischen einem Gate-Anschluss des zweiten Transistors (Tr2) und einem Source-Anschluss des ersten Transistors (Tr3) umfasst.

5. Schaltungsanordnung nach Anspruch **4,**
**dadurch gekennzeichnet, dass** die elektrisch leitende Verbindung ein Kurzschluss ist.

6. Schaltungsanordnung nach einem der vorhergehenden Ansprüche,
**dadurch gekennzeichnet, dass** bei der ersten Schaltungseinheit ein Eingangssignal gleichgerichtet ist.

7. Schaltungsanordnung nach Anspruch **6,**
**dadurch gekennzeichnet, dass** die erste Schaltungseinheit mit einem Ausgang eines Brückengleichrichters (54) verbunden ist und an einem Eingang des Brückengleichrichter (54) ein Widerstand (RO) dem Brückengleichrichter (54) parallel geschaltet ist.

8. Schaltungsanordnung nach einem der Ansprüche 1 bis **5,**
**dadurch gekennzeichnet, dass** in Reihe zu dem ersten (Tr13) und dem zweiten Transistor (Tr12) ein vierter (Tr23) und ein fünfter Transistor (Tr22) zwischen die Anschlüsse geschaltet sind und eine dritte Schaltungseinheit dazu ausgelegt ist, den vierten Transistor (Tr23) durch Ändern einer Steuerspannung an einem Steuereingang des vierten Transistors (Tr23) in Abhängigkeit von einer zwischen den Anschlüssen erfassten zweiten Spannung (U') zu steuern, wobei die zweite Spannung (U') gegensinnig zu der ersten Spannung (U) erfasst wird.

9. Messmodul (10) mit einem analogen Messeingang, wobei zwei Anschlusskontakte (14, 16) des Messeingangs über eine Schaltungsanordnung (32) gemäß einem der Ansprüche 1 bis **8** miteinander verbunden sind.

## Claims

1. Circuit arrangement for protecting an electrical load (26), comprising
- a first connection (42) and a second connection (44) which are connected to one another via a first transistor (Tr3), and
- a first circuit unit (46) which is designed to reduce a current flowing through the first transistor (Tr3) by changing a control voltage at a control input of the first transistor (Tr3) if a first voltage detected between the connections (42, 44) has a voltage value greater than a predefined value and/or if a current flowing between the connections has a current intensity greater than a predefined value, and
- a second transistor (Tr2) which is connected between the first connection (42) and the second connection (44) and is connected in series with the first transistor (Tr3), and
- a second circuit unit (48) which is designed to change a control voltage at a control input of the second transistor (Tr2) on the basis of a voltage dropped across the first transistor (Tr3) in such a manner that the current flowing through the first transistor (Tr3) is reduced if a magnitude of the voltage dropped across the first transistor (Tr3) rises,
**characterized in that**
- the first circuit unit (46) comprises a first circuit path and a second circuit path, across each of which the first voltage is dropped,
- the first circuit path comprising a resistor (R2) and at least one further element, at least part of the first voltage being dropped across the further element, and
- the second circuit path comprising a third transistor (Tr1), and
- electrical connections being provided in such a manner that a control voltage at a control input of the third transistor (Tr1) is formed on the basis of a voltage dropped across the resistor (R2), and
- the control voltage at the control input of the first transistor (Tr3) being dependent on a voltage dropped across the third transistor (Tr1).

2. Circuit arrangement according to Claim 1,
**characterized in that**
at least one of the circuit paths comprises an element, in particular an optocoupler (OPTO), which can be used to generate a signal in a circuit DC-isolated from the respective circuit path on the basis of a current flowing through the respective circuit path.

3. Circuit arrangement according to Claim 1 or 2,
**characterized in that**
the first transistor (Tr3) and the second transistor (Tr2) are each a field effect transistor, in particular a MOSFET, the connections of the circuit arrangement being connected to one another via a respective drain-source path of the field effect transistors.

4. Circuit arrangement according to Claim 3,
**characterized in that**
the first transistor (Tr3) is a normally off field effect transistor and the second transistor (Tr2) is a normally on field effect transistor, and the second circuit unit (48) comprises an electrically conductive connection between a gate connection of the second transistor (Tr2) and a source connection of the first transistor (Tr3).

5. Circuit arrangement according to Claim 4,
**characterized in that**
the electrically conductive connection is a short circuit.

6. Circuit arrangement according to one of the preceding claims,
**characterized in that**
an input signal is rectified in the first circuit unit.

7. Circuit arrangement according to Claim 6,
**characterized in that**
the first circuit unit is connected to an output of a bridge rectifier (54), and a resistor (RO) is connected in parallel with the bridge rectifier (54) at an input of the bridge rectifier (54).

8. Circuit arrangement according to one of Claims 1 to 5,
**characterized in that**
a fourth transistor (Tr23) and a fifth transistor (Tr22) are connected in series with the first transistor (Tr13) and the second transistor (Tr12) between the connections, and a third circuit unit is designed to control the fourth transistor (Tr23) by changing a control voltage at a control input of the fourth transistor (Tr23) on the basis of a second voltage (U') detected between the connections, the second voltage (U') being detected in the opposite direction to the first voltage (U).

9. Measuring module (10) having an analogue measuring input, two connecting contacts (14, 16) of the measuring input being connected to one another via a circuit arrangement (32) according to one of Claims 1 to 8.

## Revendications

1. Montage de protection d'un utilisateur ( 26 ) électrique, comprenant
- une première borne ( 42 ) et une deuxième borne ( 44 ), qui sont reliées entre elles par un premier transistor ( Tr3 ), et
- une première unité ( 46 ) de circuit conçue pour, par modification d'une tension de commande sur une entrée de commande du premier transistor ( Tr3 ), réduire un courant passant dans le premier transistor ( Tr3 ), si une première tension détectée entre les bornes ( 42, 44 ) a une valeur plus grande qu'une valeur prescrite et/ou si un courant passant entre les bornes a une intensité plus grande qu'une valeur prescrite, et
- un deuxième transistor ( Tr2 ), qui est monté entre la première borne ( 42 ) et la deuxième borne ( 44 ) et en série avec le premier transistor ( Tr3 ) , et
- une deuxième unité ( 48 ) de circuit, qui est conçue pour, en fonction d'une tension chutant aux bornes du premier transistor ( Tr3 ), modifier une tension de commande sur une entrée de commande du deuxième transistor ( Tr2 ), de manière à ce que le courant passant dans le premier transistor ( Tr3 ) soit réduit, si une valeur de la tension chutant aux bornes du premier transistor ( Tr3 ) augmente,
**caractérisé en ce que**
- la première unité ( 46 ) de circuit comprend une première et une deuxième sections de circuit aux bornes desquelles la première tension chute respectivement, dans lequel
- la première section de circuit comprend une résistance ( R2 ) et au moins un autre élément, au moins une proportion de la première tension chutant aux bornes de l'autre élément, et
- la deuxième section de circuit comprend un troisième transistor ( Tr1 ), et dans lequel
- il est prévu des liaisons électriques, de manière à ce qu'une tension de commande sur une entrée de commande du troisième transistor ( Tr1 ) soit formée en fonction d'une tension chutant aux bornes de la résistance ( R2 ) et
- la tension de commande à l'entrée de commande du premier transistor ( Tr3 ) dépend d'une tension chutant aux bornes du troisième transistor ( Tr1 ).

2. Montage suivant la revendication 1,
**caractérisé en ce que**
au moins l'une des sections de circuit comprend un élément, notamment un optocoupleur ( OPTO ), par lequel, en fonction d'un courant passant dans la section respective de circuit, un signal peut être produit dans un circuit séparé galvaniquement de la section respective de circuit.

3. Montage suivant la revendication 1 ou 2,
**caractérisé en ce que**
le premier transistor ( Tr3 ) et le deuxième transistor ( Tr2 ) est respectivement un transistor à effet de champ, notamment un MOSFET, les bornes du montage étant reliées entre elles par une section respective de drain-source des transistors à effet de champ.

4. Montage suivant la revendication 3,
**caractérisé en ce que**
le premier transistor ( Tr3 ) est un transistor à effet de champ normalement bloqué et le deuxième transistor ( Tr2 ) est un transistor à effet de champ normalement passant et la deuxième unité ( 48 ) de circuit comprend une liaison conductrice de l'électricité entre une borne de grille du deuxième transistor ( TR2 ) et une borne de source du premier transistor ( Tr3 ).

5. Montage suivant la revendication 4,
**caractérisé en ce que**
la liaison conductrice de l'électricité est un court-circuit.

6. Montage suivant l'une des revendications précédentes,
**caractérisé en ce que**
un signal d'entrée est redressé dans la première unité de circuit.

7. Montage suivant la revendication 6,
**caractérisé en ce que**
la première unité de circuit est reliée à une sortie d'un redresseur ( 54 ) en pont et une résistance ( RO ) du redresseur ( 54 ) en pont est montée en parallèle sur une entrée du redresseur ( 54 ) en pont.

8. Montage suivant l'une des revendications 1 à5,
**caractérisé en ce que**
en série avec le premier ( Tr13 ) et le deuxième transistors ( Tr12 ) sont montés entre les bornes, un quatrième ( Tr23 ) et un cinquième transistors ( Tr22 ) et une troisième unité de circuit est conçue pour commander le quatrième transistor ( Tr23 ) en modifiant une tension de commande sur une entrée de commande du quatrième transistor ( Tr23 ) en fonction d'une deuxième tension ( U' ) détectée entre les bornes, la deuxième tension ( U' ) étant détectée en sens contraire à la première tension ( U ).

9. Module ( 10 ) de mesure ayant une entrée de mesure analogique, deux contacts ( 14, 16 ) de borne de l'entrée de mesure étant reliés entre elles par un montage ( 32 ) suivant l'une des revendications 1 à 8.
